# FASCICULE DE BREVET EUROPEEN

(11) **EP 1 344 434 B1**
(45) Date de publication et mention de la délivrance du brevet: **28.02.2007**
(21) Numéro de dépôt: 01271032.3
(22) Date de dépôt: 10.12.2001
(51) Int. Cl.: H05K 3/34, B23K 3/08

(54) **PROCEDE DE REALISATION D'UNE BRASURE ENTRE DES BILLES METALLIQUES D'UN COMPOSANT ELECTRONIQUE ET DES PLAGES D'ACCUEIL D'UN CIRCUIT ET FOUR DE BRASAGE POUR LA MISE EN OEUVRE DE CE PROCEDE**
VERFAHREN ZUR HERSTELLUNG EINER LÖTUNG ZWISCHEN METALLISCHEN KUGELN EINES ELEKTRONISCHEN BAUELEMENTS UND KONTAKTFLECKEN EINER SCHALTUNG UND LÖTOFEN DAFÜR
METHOD FOR MAKING A SOLDER BETWEEN METALLIC BALLS OF AN ELECTRONIC COMPONENT AND MOUNTING LANDS OF A CIRCUIT AND SOLDERING FURNACE THEREFOR

(30) Priorité: 11.12.2000 FR 0016061
(43) Date de publication de la demande: 17.09.2003
(73) Titulaire: L'Air Liquide Société Anonyme à Directoire et Conseil de Surveillance pour l'Etude et l'Exploitation des Procédés Georges Claude, 75321 Paris Cedex 07 (FR)
(72) Inventeur: BONET, Claude, F-75014 Paris (FR)
(74) Mandataire: Mellul-Bendelac, Sylvie Lisette
(86) Numéro de dépôt international: PCT/FR2001/003898
(87) Numéro de publication internationale: WO 2002/049401

(56) Documents cités:
- DE-A- 19 925 652
- US-A- 5 222 649
- US-A- 5 232 145
- US-A- 5 333 774
- PATENT ABSTRACTS OF JAPAN vol. 1997, no. 01, 31 janvier 1997 (1997-01-31) & JP 08 236921 A (MATSUSHITA ELECTRIC IND CO LTD), 13 septembre 1996 (1996-09-13)
- PATENT ABSTRACTS OF JAPAN vol. 1997, no. 04, 30 avril 1997 (1997-04-30) & JP 08 340177 A (MATSUSHITA ELECTRIC IND CO LTD), 24 décembre 1996 (1996-12-24)
- PATENT ABSTRACTS OF JAPAN vol. 009, no. 284 (E-357), 12 novembre 1985 (1985-11-12) & JP 60 124947 A (NIPPON TELEGR & TELEPH CORP), 4 juillet 1985 (1985-07-04)
- PATENT ABSTRACTS OF JAPAN vol. 015, no. 244 (M-1127), 24 juin 1991 (1991-06-24) & JP 03 077772 A (AIWA CO LTD), 3 avril 1991 (1991-04-03)
- PATENT ABSTRACTS OF JAPAN vol. 1998, no. 09, 31 juillet 1998 (1998-07-31) & JP 10 093232 A (NIHON DENNETSU KK), 10 avril 1998 (1998-04-10)

## Description

L'invention concerne le domaine de l'assemblage des composants électroniques. Plus précisément elle concerne notamment le montage des boîtiers surfaciques à sorties périphériques matricielles de type BGA (ball grid array) ou CSP (chip scale package) sur dès circuits imprimés, et également celui du FCOB (flip chip on board), ainsi que l'assemblage de ces boîtiers eux-mêmes.

Ces boîtiers renferment une puce de silicium, un circuit intégré, et sont destinés à être montés sur des cartes qui sont ensuite implantées dans des appareils électroniques. Ils trouvent présentement une application de masse privilégiée dans les téléphones portables GSM de technologie avancée. Alors que dans les boîtiers de précédentes générations, les connexions avec le circuit imprimé sont assurées par des pattes situées à la périphérie d'un boîtier par exemple de type QFP (quad flat package) ou analogue, les boîtiers BGA, micro-BGA ou CSP comportent à cet effet des éléments de contact sous forme de billes en alliage eutectique Sn-Pb contenant 63% d'étain et 37% de plomb (alliage eutectique à 183°C ; on peut éventuellement y ajouter quelques % d'argent). Le boîtier est assemblé par brasage par refusion des billes sur le circuit imprimé en même temps que les autres composants de la carte.

Le circuit imprimé multi-couches est, habituellement, lui-même constitué d'un empilement de couches comportant chacune des pistes conductrices en cuivre, reliées par des vias d'interconnexion et déposées sur un support isolant, par exemple en résine époxy et fibre de verre. Le circuit imprimé comporte en sus, sur ses faces externes, des plages en cuivre pour l'accueil du composant à braser, chaque plage d'accueil venant au contact d'une bille du boîtier lors de la pose de ce dernier par une machine de placement. La plage d'accueil en cuivre a été revêtue par le fabricant du circuit d'une couche de finition comportant une sous-couche de nickel de 5 à 10 µm et un film d'or superficiel de 500 à 1000 Å d'épaisseur pour la résistance à l'oxydation, constituant une surface de finition plane et soudable.

Il est à noter que le nickel, s'il a été déposé par un procédé chimique (donc non électrolytique), contient jusqu'à 10% en atomes de phosphore, car cet élément est associé à la formulation de la solution de nickel utilisée pour le dépôt chimique du nickel. L'assemblage du boîtier sur le circuit imprimé est effectué par brasage dans un four de refusion. A cet effet, on dépose sur les zones à braser du circuit imprimé un plot de crème à braser comportant des micro-billes d'alliage étain-plomb de même composition que les billes du boîtier, un flux de brasage et également divers adjuvants organiques, activateurs et agents de texture. Après sérigraphie de la crème à braser, puis pose du boîtier sur le circuit imprimé, la carte est entraînée dans le four sur un convoyeur, pour y réaliser le brasage en un passage, suivant un profil précis de température/temps, sous atmosphère d'azote ou sous air. La crème à braser et les billes d'alliage sont chauffées en plusieurs étapes comportant des vitesses de montée typiquement de l'ordre de 1,2 ou 3°C/s jusqu'à 220/230°C, soit une température supérieure à celle de l'eutectique. Le temps passé à l'état liquide varie au total typiquement entre 40 s et 90 s. La température maximale est le pic de refusion au delà duquel commence le refroidissement. Celui-ci s'effectue de manière habituelle à une vitesse qui n'excède pas 2°C/s, et généralement est de 1 à 2°C/s. On peut, par exemple, prélever de l'azote chaud présent dans le four et le mettre en circulation dans une « boîte froide », qui sert aussi de piège pour les vapeurs issues du flux de brasage et est refroidie par circulation d'eau à 10°C. Cet azote refroidi et épuré en flux est réinjecté dans le four au niveau du lieu où est atteint le pic de refusion, pour refroidir la carte.

A l'issue du brasage, on a donc réalisé le joint de brasure qui forme une connexion mécanique et électrique stable et durable et qui présente plusieurs couches successives :
- le cuivre de la plage d'accueil du circuit imprimé ;
- une couche de nickel renfermant du phosphore si ce nickel est d'origine chimique;
- une couche d'un composé intermétallique, étain-nickel-phosphore d'épaisseur de l'ordre de 1µm) ;
- l'alliage étain-plomb 63/37.

L'or ayant été dissout par l'alliage étain-plomb au cours du brasage, il ne joue plus aucun rôle dans le processus.

Il est également à noter que l'implantation des billes d'alliage étain-plomb sur le boîtier BGA lui-même est effectué selon une séquence d'opérations tout à fait similaire, et mettant en jeu les mêmes opérations métallurgiques. Le fond du boîtier en résine comporte des plages en cuivre revêtues d'une couche de finition nickel/or, sur chacune desquelles on dispose un flux adhésif, puis une bille d'alliage étain-plomb. L'ensemble est ensuite introduit dans un four pour réaliser le brasage par refusion des billes sur les plages d'accueil.

La présence de la couche de composé intermétallique pose problème lorsqu'il s'agit d'un mélange ternaire nickel-étain-phosphore, car ce composé possède un comportement mécanique de type fragile. Cette fragilité intrinsèque rend la liaison boîtier/circuit imprimé ou la liaison bille/boîtier sensible aux chocs, d'autant que la géométrie même de la zone de contact bille-pastille induit une concentration des contraintes dans cette même zone de contact. Un mode de rupture dit fragile, associé à la propagation rapide de microfissures, est donc particulièrement susceptible de se produire à son niveau lorsque le boîtier ou l'appareil auquel est intégré la carte, est soumis à un choc. Ce phénomène est particulièrement mis en évidence lors de l'essai qui consiste à laisser tomber plusieurs fois un appareil (tel qu'un téléphone portable) d'une hauteur prédéterminée (essai appelé couramment "drop test").

Dans le cas des liaisons carte/boîtier, on essaie habituellement de remédier à ce problème en pratiquant un renforcement de la liaison mécanique par une injection de résine sous le boîtier à la base des billes postérieurement au brasage (« under-filling »). Cette résine présente en outre l'avantage d'absorber les contraintes mécaniques associées aux différences de coefficient de dilatation thermique entre les divers matériaux du système. Mais son application impose une étape de fabrication supplémentaire qui complique la fabrication de la carte et grève son prix de revient.

Le but de l'invention est de proposer un procédé d'assemblage d'une carte comportant au moins un boîtier surfacique à billes de type BGA ou CSP ou analogue permettant d'obtenir un produit d'une plus grande fiabilité que les produits connus, en particulier du point de vue de sa résistance aux chocs, sans pour autant nécessiter le recours à une résine de renforcement. Un autre but est de proposer un procédé d'assemblage des billes sur le boîtier présentant la même fiabilité.

A cet effet l'invention a pour objet un procédé de réalisation d'une brasure entre des billes métalliques faisant partie, ou destinées à faire partie, d'un boîtier de type BGA ou CSP ou analogue et des plages d'accueil appartenant à un circuit imprimé déposé sur un support ou à un circuit intégré renfermé dans ledit boîtier, selon lequel :
- on dépose une crème à braser ou un flux adhésif sur lesdites plages d'accueil ;
- on place lesdites billes sur lesdites plages d'accueil ;
- et on introduit l'ensemble dans un four de brasage par refusion de manière à porter les billes métalliques au dessus de leur température de fusion;
caractérisé en ce qu'on effectue un refroidissement forcé du support et/ou du boîtier de manière à abréger le temps de séjour des billes à l'état liquide en imposant aux billes une vitesse de refroidissement de 5°C/s au moins.

On peut imposer aux billes une vitesse de refroidissement préférentiellement comprise entre 5 et 10°C/s.

Le temps de séjour des billes à l'état liquide pendant le refroidissement peut être compris entre 3 et 6 s environ.

Le temps de séjour total des billes métalliques, à l'état liquide peut être compris entre 20s et 65s.

Dans un exemple privilégié de mise en oeuvre de l'invention, ladite plage d'accueil comporte une couche de finition constituée par du nickel renfermant du phosphore, éventuellement revêtu par un film d'or, et les billes métalliques sont en un alliage à base d'étain et de plomb.

Dans ces conditions, on impose de préférence aux billes métalliques et à la crème à braser une température, un temps de séjour à l'état liquide et une vitesse de refroidissement tels qu'ils conduisent à la formation à l'interface bille-plage d'accueil d'une couche intermétallique étain-nickel-phosphore d'épaisseur maximale 0,5µm.

L'invention a également pour objets :
- une carte comportant au moins un circuit imprimé déposé sur un support et au moins un circuit intégré renfermé dans un boîtier de type BGA ou CSP ou analogue, caractérisée en ce qu'elle est susceptible d'être obtenue par le procédé précédemment décrit ;
- un boîtier de type BGA ou CSP ou analogue, caractérisé en ce qu'il est susceptible d'être obtenu par le procédé précédemment décrit.

L'invention a enfin pour objet un four de brasage par refusion pour l'assemblage de cartes comportant au moins un circuit imprimé déposé sur un support et au moins un circuit intégré renfermé dans un boîtier de type BGA, CSP ou analogue, ou pour la fabrication de tels boîtiers, caractérisé en ce qu'il comporte en fin de zone de brasage des moyens de refroidissement forcé du support de la carte et/ou du boîtier permettant d'imposer aux billes une vitesse de refroidissement d'au moins 5°C/s.

Lesdits moyens de refroidissement forcé peuvent être constitués par au moins un injecteur projetant un jet de gaz sur la face inférieure du support de la carte et/ou sur le boîtier.

Le four peut alors comporter des moyens de refroidissement, du gaz avant sa projection par l'injecteur.

Ledit gaz peut être un gaz ou un mélange de gaz à forte conductivité thermique, tel que l'hydrogène ou l'hélium.

Lesdits moyens de refroidissement forcé peuvent aussi être constitués par des moyens pour projeter sur le support de la carte et/ou sur le boîtier un milieu cryogénique, tel qu'un écoulement diphasique gaz/liquide ou gaz/solide, par exemple une suspension de gouttelettes d'azote liquide transportées par de l'azote gazeux, ou encore une suspension de neige carbonique transportée par du CO₂.

Lesdits moyens pour projeter sur le support de la carte et/ou sur le boîtier un écoulement diphasique gaz/liquide ou gaz/solide peuvent comporter une buse ou un ensemble de buses se déplaçant perpendiculairement à la carte ou au boîtier, ou une buse ou un ensemble de buses fixes arrosant sélectivement le boîtier au moment où il passe devant la ou lesdites buses.

Le four selon l'invention comporte de préférence des moyens d'inertage évitant la présence d'air au moins dans la zone où s'effectuent la brasure et le refroidissement de la zone brasée.

Les moyens de projection d'un écoulement diphasique gaz/liquide sont, de préférence, reliés à une source de gaz liquide par l'intermédiaire d'une canalisation isolée sous vide.

Dans le cas où on utilise une suspension de neige carbonique dans du CO₂ gazeux, les moyens de projection sont, de préférence, reliés à une source de CO₂ liquide sous pression par l'intermédiaire d'une canalisation isolée et d'un pot de détente.

Comme on l'aura compris, l'invention consiste à ajouter aux étapes classiques de la fabrication de la carte ou du boîtier une étape de refroidissement forcé énergique de la carte ou du boîtier, effectuée de manière à n'obtenir qu'un bref temps de séjour à l'état liquide des billes métalliques et du mélange qu'elles forment avec la crème à braser ou le flux adhésif pendant le brasage, postérieurement à l'atteinte du pic de refusion. Ce refroidissement forcé énergique permet de contrôler la croissance de la couche de composé intermétallique.

L'invention sera mieux comprise à la lecture de la description qui suit, détaillant un exemple non limitatif de mise en oeuvre de l'invention. Dans cet exemple, on se donne pour objectif d'assembler une carte comportant un circuit imprimé constitué par des pistes et des plages d'accueil de cuivre sur un support FR4 (résine époxy et fibre de verre) et un boîtier surfacique de type BGA standard (de dimensions 27mm x 27mm, de poids 2,62g, d'épaisseur hors tout 2,4mm, comportant 256 billes de 0,5mm de diamètre au pas de 1,27mm).

Comme il est classique, la surface des plages d'accueil du circuit imprimé avec des pistes cuivre de 25 µm d'épaisseur est revêtue par une couche de finition de 5 µm de nickel déposée par voie chimique, ce qui a pour conséquence l'inclusion de plusieurs % en atomes de phosphore dans le dépôt de nickel (jusqu'à 10%). Un dépôt d'or par immersion de 500-1000Å recouvre le nickel et le protège de l'oxydation. Comme il est également classique, les éléments de contact du boîtier sont constitués par des billes d'un alliage eutectique étain-plomb (63-37%) pouvant contenir également un peu d'argent (2% en masse).

Selon un mode opératoire connu, on dépose par sérigraphie sur les zones à braser du circuit imprimé une crème à braser à base d'étain et de plomb, dont le flux, ses activateurs et les divers adjuvants organiques sont destinés à contribuer à éliminer les oxydes et à nettoyer les surfaces métalliques à braser au contact de la crème. Puis le boîtier est mis en place sur le circuit imprimé, et l'assemblage ainsi constitué est introduit dans le four de brasage par refusion du type radiatif, ou convectif, ou mixte, où il se déplace entre l'entrée et la sortie du four à une vitesse de l'ordre de 1m/min.

D'une manière classique, la carte traverse une première zone du four où elle subit un préchauffage à une vitesse de 0,6 à 2°C/s, qui la porte à une température de 150°C environ. Puis, dans une deuxième zone du four, la carte séjourne à une température de 150 à 180°C pendant 45 à 90s. C'est pendant cette phase que le flux joue son rôle d'élimination des oxydes et de nettoyage des surfaces à braser.

Le brasage proprement dit a lieu dans une troisième étape, où les billes d'alliage étain-plomb et la crème à braser coalescent lorsqu'elles sont portées à l'état liquide, jusqu'à une température maximale de l'ordre de 200-225°C (le pic de refusion). Dans les procédés connus où on injecte de l'azote refroidi par un échangeur à eau froide (10°C) dans la zone du pic de refusion pour atteindre une vitesse de refroidissement de 1 à 2°C/s, les billes séjournent à l'état liquide pendant 45 à 90s au total.

En revanche, dans le procédé selon l'invention, on limite le temps de séjour de la brasure à l'état liquide en lui appliquant un refroidissement forcé énergique dans la fin de la zone de brasage du four, typiquement dès que le pic de refusion est atteint. Le temps de séjour total de la brasure à l'état liquide doit être suffisant pour que la pellicule d'or ait le temps de se dissoudre, pour que la surface du revêtement de nickel puisse être bien mouillée par l'alliage étain-plomb, et pour que l'étain diffuse superficiellement dans le nickel en garantissant la bonne réalisation de la brasure, grâce à la formation de la couche de diffusion intermétallique.

L'application d'un refroidissement forcé énergique après l'atteinte du pic de refusion permet de réduire l'épaisseur de la couche de composé intermétallique étain-nickel-phosphore qui se forme à l'interface nickel/bille. Les autres caractéristiques de la brasure sont conservées par rapport à la pratique habituelle.

L'expérience montre qu'une réduction par refroidissement forcé énergique du temps de séjour des billes d'étain-plomb à l'état liquide de 30 à 50% par rapport à la pratique habituelle, où on les fait se refroidir à 1-2°C/s, donne de bons résultats. Par rapport à la pratique habituelle précédemment décrite, cela conduit à imposer aux billes un temps de séjour total à 'l'état liquide (comprenant donc la phase de chauffage et la phase de refroidissement) de 20 à 60s environ. Pour abréger ce temps de séjour, on impose aux billes une vitesse de refroidissement d'au moins 5°C/s, par exemple 10°C/s. Il n'est pas-nécessaire de procéder à une véritable trempe du métal (pour laquelle la vitesse de refroidissement serait très supérieure), mais à un refroidissement forcé contrôlé plus énergique que ceux habituellement pratiqués. L'état liquide est donc maintenu pendant environ 3 à 6s lors du refroidissement, alors que ce temps est de l'ordre de 30s habituellement. De cette façon, on vise à obtenir une épaisseur maximale de 0,5 µm pour la couche de composé intel-métallique étain-nickel-phosphore, à comparer à l'épaisseur de 1 µm environ obtenue habituellement.

On estime que pour obtenir les vitesses de refroidissement désirées, les moyens de refroidissement doivent être capables de réaliser un échange thermique avec la carte et/ou le boîtier caractérisé par une densité de flux d'au moins 1W/cm² et jusqu'à 3W/cm².

Des mesures, directes ou des estimations de la température des zones à refroidir peuvent avantageusement être réalisées à l'aide de pyromètres optiques ou de thermocouples. On peut ainsi vérifier en cours de fonctionnement du four que les réglages des différents paramètres opératoires permettent d'obtenir la vitesse de refroidissement nécessaire.

Pour obtenir ce refroidissement contrôlé, plusieurs exemples de solutions peuvent être proposés.

Dans un premier exemple, on insuffle à fort débit un gaz tel que de l'azote sur la carte et/ou sur le boîtier. Ce gaz peut, au préalable, avoir été refroidi, soit dans un échangeur à eau à 10°C, soit dans un échangeur à azote liquide qui donne un gaz froid, par exemple à environ -100°C. Cette insufflation peut être effectuée au moyen d'un ou plusieurs "injecteurs", c'est à dire des éléments d'insufflation pourvus d'une ou plusieurs fentes ou orifices cylindriques par lesquels sort le gaz, et que l'on oriente vers la ou les zones à refroidir. Si une insufflation de gaz sur la face inférieure de la carte peut, dans certains cas, suffire pour obtenir le résultat désiré, on obtient une vitesse de refroidissement supérieure de la zone de brasage si on insuffle le gaz directement sur le boîtier. Bien entendu, ces deux modes de refroidissement peuvent être combinés pour obtenir, si nécessaire, un refroidissement plus rapide. A titre d'exemple, on peut utiliser un débit d'azote gazeux de 15Nm³/h pour une injection effectuée sur une largeur de 0,30m.

On peut, dans un deuxième exemple, améliorer le mode opératoire précédent en utilisant à l'état pur un gaz à forte conductivité thermique, tel que l'hydrogène ou l'hélium, ou un mélange de tels gaz. Alors qu'avec des gaz plus courants tels que l'azote, les transferts thermiques entre le gaz et la zone de brasage s'effectuent essentiellement par convection, dans ce deuxième exemple la part de la conduction dans les transferts thermiques devient significative et on peut obtenir un refroidissement plus rapide si nécessaire. Là encore, à titre d'exemple, un débit d'hydrogène ou d'hélium de 50Nm³/h pour une largeur d'injection de 0,30 m peut être proposé. On peut utiliser l'hydrogène et l'hélium en circuit fermé, à condition de les épurer partiellement de l'azote qui les a pollués avant de les réinjecter dans le four.

Ces deux exemples sont utilisables dans les cas où l'obtention d'une vitesse de refroidissement suffisante n'impose pas l'insufflation du gaz à une vitesse exagérément élevée au point de risquer l'arrachement du boîtier sous l'effet de la poussée du gaz, ou l'arrachement des petits composants dénommés « chips », qui, parce qu'ils présentent à la fois une taille et une masse très faible en comparaison du boîtier BGA, peuvent être arrachés de la carte ou déplacés si le jet de gaz est trop violent.

Dans un troisième exemple, on réalise le refroidissement de la zone de brasage en projetant sur toute la largeur de la face supérieure de la carte un écoulement diphasique gaz/liquide (par exemple une suspension de gouttelettes d'azote liquidé transportées par de l'azote gazeux dans une proportion 90% liquide/10% gaz en masse) ou gaz/solide (par exemple une suspension de neige carbonique dans du CO₂ gazeux, dans une proportion 55% neige/ 45% gaz en masse) au moyen d'une buse ou d'un ensemble de buses se déplaçant perpendiculairement à la carte. Dans cette dernière disposition on préférera des buses à jet plat placées côte à côte, qui vont réaliser un arrosage efficace de la totalité de la carte en mouvement. Le refroidissement recherché peut, à titre d'exemple, être obtenu à l'aide d'un débit d'azote liquide de 0,2 l/h et par buse.

Dans une autre variante de cet exemple, on utilise une buse ou un ensemble de buses fixe, qui projette sélectivement sur le boîtier l'écoulement diphasique au moment où il passe devant la ou les buses. La géométrie de la buse ou de l'ensemble de buses est fonction de la taille du boîtier.

L'arrosage de la face supérieure de la carte ou l'arrosage du boîtier peuvent être remplacés ou complétés par un arrosage de la face inférieure du support de la carte.

Par rapport aux modes opératoires précédents celui-ci présente l'avantage de ne pas entraîner de risques d'arrachage du boîtier. Le refroidissement recherché peut être obtenu, à titre d'exemple, à l'aide d'un débit d'azote liquide de 0,2 l/h pour chaque buse, le nombre de buses variant selon la largeur de la zone à arroser (selon en particulier, que l'on désire refroidir la totalité de la largeur de la carte, ou refroidir sélectivement le boîtier). La buse ou l'ensemble de buses est relié au réservoir d'azote liquide sous pression de 3 bars par l'intermédiaire d'une canalisation isolée sous vide, qui permet de minimiser les pertes de liquide par évaporation avant l'arrivée dans le four. Si on utilise un réservoir de CO₂ liquide, on dispose un pot de détente à 8 bars entre la buse et le réservoir qui est sous une pression de 30 bars. La canalisation peut n'être isolée que par de la mousse organique.

Dans tous les cas, il est conseillé de prévoir des moyens d'inertage gazeux du four de brasage, permettant de limiter ou d'éviter la présence d'oxygène à l'intérieur du four, au moins dans la zone où ont lieu le brasage et le refroidissement de la zone brasée. En effet, la présence d'oxygène tend à détériorer la mouillabilité du nickel revêtu par l'or, alors que cette mouillabilité est bonne dans une atmosphère inerte, telle que l'azote pur. Le gaz utilisé pour le refroidissement peut participer à cet inertage.

L'invention a été décrite dans le cadre d'une application à la fabrication de cartes au moyen d'une brasure cuivre-nickel-étain/plomb, avec un alliage étain/plomb eutectique. Mais il va de soi qu'elle peut être utilisée pour fabriquer des cartes utilisant d'autres matériaux pour leur assemblage, s'il s'avère qu'un refroidissement forcé selon l'invention permet d'y limiter la formation de composés intermétailiques qui, présents en trop grande quantité, seraient fragilisants pour les brasures. En particulier, on peut utiliser un alliage étain/plomb non eutectique, ou même un alliage dit sans plomb eutectique ou non eutectique, à base d'étain et comportant un ou deux ou trois éléments d'addition pris parmi les métaux suivants tels que décrits dans la littérature: argent, cuivre, antimoine, bismuth, zinc, indium, pour former un alliage binaire, ternaire ou quaternaire.

Il va également de soi que le procédé peut être appliqué à la fabrication de cartes comportant plusieurs boîtiers. Le nombre et la disposition des moyens de refroidissement forcé sont alors à adapter en conséquence. Par exemple s'agissant d'une carte équipée de boîtiers BGA sur les deux faces on pourra avantageusement utiliser l'invention sur la première face seulement puis sur les deux faces simultanées pour éviter que le boîtier BGA déjà brasé n'entre une deuxième fois en refusion lors du deuxième passage.

Enfin, le procédé est adaptable à l'opération de fabrication des boîtiers à billes, de type BGA ou analogues, lors de laquelle on effectue la fixation des billes sur les plages d'accueil du boîtier par brasage. Les conditions requises pour obtenir une liaison de bonne qualité entre les billes et les plages d'accueil sont les mêmes, et pour les mêmes raisons, à savoir l'obtention d'une couche de composé intermétallique d'épaisseur réduite à l'interface bille/plage d'accueil.

## Revendications

1. Procédé de réalisation d'une brasure entre des billes métalliques faisant partie, ou destinées à faire partie, d'un boîtier de type BGA ou CSP ou analogue et des plages d'accueil appartenant à un circuit imprimé déposé sur un support ou à un circuit intégré renfermé dans ledit boîtier, selon lequel :
- on dépose une crème à braser ou un flux adhésif sur lesdites plages d'accueil,
- on place lesdites billes sur lesdites plages d'accueil ;
- et on introduit l'ensemble dans un four de brasage par refusion de manière à porter les billes métalliques au dessus de leur température de fusion;
**caractérisé en ce qu'**on effectue un refroidissement forcé du support et/ou du boîtier de manière à abréger le temps de séjour des billes à l'état liquide en imposant aux billes une vitesse de refroidissement de 5°C/s au moins.

2. Procédé selon la revendication 1, **caractérisé en ce qu'**on impose aux billes une vitesse de refroidissement comprise entre 5 et 10°C/s.

3. Procédé selon la revendication 1 ou 2, **caractérisé en ce que** le temps de séjour des billes à l'état liquide pendant le refroidissement est compris entre 3 et 6s environ.

4. Procédé selon l'une des revendications 1 à 3, **caractérisé en ce que** le temps de séjour total des billes métalliques à l'état liquide est compris entre 20s et 65s.

5. Procédé selon l'une des revendications 1 à 4, **caractérisé en ce que** ladite plage d'accueil comporte une couche de finition constituée par du nickel renfermant du phosphore, éventuellement revêtu par un film d'or, et **en ce que** les billes métalliques sont en un alliage à base d'étain et de plomb.

6. Procédé selon la revendication 5, **caractérisé en ce qu'**on impose aux billes métalliques et à la crème à braser ou au flux adhésif une température, un temps de séjour à l'état liquide et une vitesse de refroidissement tels qu'ils conduisent à l'interface bille-plage d'accueil à la formation d'une couche intermétallique étain-nickel-phosphore d'épaisseur maximale 0,5µm.

7. Carte comportant au moins un circuit imprimé déposé sur un support et au moins un circuit intégré renfermé dans un boîtier de type BGA ou CSP ou analogue, **caractérisée en ce qu'**elle est susceptible d'être obtenue par le procédé selon l'une des revendications 1 à 6.

8. Boîtier de type BGA ou CSP ou analogue, **caractérisé en ce qu'**il est susceptible d'être obtenu par le procédé selon l'une des revendications 1 à 6.

9. Four de brasage par refusion pour, l'assemblage de cartes du type comportant au moins un circuit imprimé déposé sur un support et au moins un circuit intégré renfermé dans un boîtier à billes de type BGA, CSP ou analogue, ou pour la fabrication de tels boîtiers, **caractérisé en ce qu'**il comporte en fin de zone de brasage des moyens de refroidissement forcé du support de la carte et/ou du boîtier permettant d'imposer aux billes une vitesse de refroidissement d'au moins 5°C/s.

10. Four selon la revendication 9, **caractérisé en ce que** lesdits moyens de refroidissement forcé sont constitués par au moins un injecteur projetant un jet de gaz sur la face inférieure du support de la carte et/ou sur le boîtier.

11. Four selon la revendication 10, **caractérisé en ce qu'**il comporte des moyens de refroidissement du gaz avant sa projection par l'injecteur.

12. Four selon la revendication 10 ou 11, **caractérisé en ce que** ledit gaz est un gaz ou un mélange de gaz à forte conductivité thermique, tel que l'hydrogène ou l'hélium.

13. Four selon la revendication 9, **caractérisé en ce que** lesdits moyens de refroidissement forcé sont constitués par des moyens pour projeter sur le support de la carte et/ou sur le boîtier un écoulement diphasique gaz/liquide.

14. Four selon la revendication 13, **caractérisé en ce que** ledit écoulement diphasique gaz/liquide est une suspension de gouttelettes d'azote liquide transportées par de l'azote gazeux.

15. Four selon la revendication 9, **caractérisé en ce que** lesdits moyens de refroidissement forcé sont constitués par des moyens pour projeter sur le support de la carte et/ou sur le boîtier un écoulement diphasique gaz/solidé.

16. Four selon la revendication 15, **caractérisé en ce que** ledit écoulement diphasique est une suspension de neige carbonique transportée par du CO₂ gazeux.

17. Four selon l'une des revendications 13 à 16, **caractérisé en ce que** lesdits moyens pour projeter sur le support de la carte et/ou sur le boîtier un écoulement diphasique gaz/liquide ou gaz/solide comportent une buse ou un ensemble de buses se déplaçant perpendiculairement à la carte ou au boîtier.

18. Four selon l'une des revendications 13 à 16, **caractérisé en ce que** lesdits moyens pour projeter sur le support de la carte et/ou sur le boîtier un écoulement diphasique gaz/liquide ou gaz/solide comportent une buse ou un ensemble de buses fixes arrosant sélectivement le boîtier au moment où il passe devant la ou lesdites buses.

19. Four selon l'une des revendications 9 à 18, **caractérisé en ce qu'**il comporte des moyens d'inertage évitant la présence d'air au moins dans la zone où s'effectuent la brasure et le refroidissement de la zone brasée.

20. Four selon la revendication 13 ou 14, **caractérisé en ce que** lesdits moyens pour projeter sur le support de la carte et/ou sur le boîtier un écoulement diphasique gaz/liquide sont reliés à une source de gaz liquide par l'intermédiaire d'une canalisation isolée sous vide.

21. Four selon la revendication 16, **caractérisé en ce que** les moyens pour projeter sur le support de la carte et/ou le boîtier un écoulement diphasique gaz/solide constitué par une suspension de neige carbonique dans du CO₂ sont reliés à une source de CO₂ liquide sous pression par l'intermédiaire d'une canalisation isolée et d'un pot de détente.

## Claims

1. Method of producing a soldered joint between metal balls forming part, or intended to form part, of a BGA-type or CSP-type package or the like and receiving pads belonging to a printed circuit deposited on a substrate or to an integrated circuit contained in the said package, in which:
- a solder cream or an adhesive flux is deposited on the said receiving pads;
- the said balls are brought onto the said receiving pads;
- the assembly is put into a reflow soldering oven so as to heat the metal balls above their melting point,
**characterized in that** the substrate and/or package are/is forcibly cooled so as to shorten the residence time of the balls in the liquid state by subjecting the balls to a cooling rate of at least 5°C/s.

2. Method according to Claim 1, **characterized in that** a cooling rate of between 5 and 10°C/s is imposed on the balls.

3. Method according to Claim 1 or 2, **characterized in that** the residence time of the balls in the liquid state during the cooling is between 3 and 6 s approximately.

4. Method according to one of Claims 1 to 3, **characterized in that** the total residence time of the metal balls in the liquid state is between 20 s and 65 s.

5. Method according to one of Claims 1 to 4, **characterized in that** the said receiving pad has a top coat consisting of nickel containing phosphorus, possibly coated with a gold film, and **in that** the metal balls are made of an alloy based on tin and lead.

6. Method according to Claim 5, **characterized in that** the metal balls and the solder cream or the adhesive flux are subjected to a temperature, a residence time in the liquid state and a cooling rate such that they result in the formation, at the ball/receiving pad interface, of a tin/nickel/phosphorus intermetallic layer having a maximum thickness of 0.5 µm.

7. Card having at least one printed circuit deposited on a substrate and at least one integrated circuit contained in a BGA- or CSP-type package or the like, **characterized in that** it can be obtained by the method according to one of Claims 1 to 6;

8. Package of the BGA or CSP type or the like, **characterized in that** it can be obtained by the method according to one of Claims 1 to 6.

9. Reflow soldering oven for the assembly of cards of the type having at least one printed circuit deposited on a substrate and at least one integrated circuit contained in a package having balls of the BGA or CSP type or the like, or for the fabrication of such packages, **characterized in that** it includes, at the end of the soldering zone, means for forcibly cooling the substrate of the card and/or the package, making it possible to cool the balls at a cooling rate of at least 5°C/s.

10. Oven according to Claim 9, **characterized in that** the said forced cooling means consist of at least one injector blasting a jet of gas onto the lower side of the substrate of the card and/or onto the package.

11. Oven according to Claim 10, **characterized in that** it includes means for cooling the gas before it is blasted by the injector.

12. Oven according to Claim 10 or 11, **characterized in that** the said gas is a gas or a gas mixture having a high thermal conductivity, such as hydrogen or helium.

13. Oven according to Claim 9, **characterized in that** the said forced cooling means consist of means for blasting a gas/liquid 2-phase flow onto the substrate of the card and/or onto the package.

14. Oven according to Claim 13, **characterized in that** the said gas/liquid 2-phase flow is a suspension of liquid nitrogen droplets transported by gaseous nitrogen.

15. Oven according to Claim 9, **characterized in that** the said forced cooling means consist of means for blasting a gas/solid 2-phase flow onto the substrate of the card and/or onto the package.

16. Oven according to Claim 15, **characterized in that** the said 2-phase flow is a suspension of carbon dioxide snow transported by gaseous CO₂.

17. Oven according to one of Claims 13 to 16, **characterized in that** the said means for blasting a gas/liquid or gas/solid 2-phase flow onto the substrate of the card and/or onto the package comprise a nozzle or number of nozzles moving perpendicular to the card or onto the package.

18. Oven according to one of Claims 13 to 16, **characterized in that** the said means for blasting a gas/liquid or gas/solid 2-phase flow onto the substrate of the card and/or onto the package comprise a fixed nozzle or number of nozzles selectively spraying the package as it moves past the said nozzle or nozzles.

19. Oven according to one of Claims 9 to 18, **characterized in that** it includes inerting means which prevent the presence of air at least in the zone where the soldering and the cooling of the soldered region take place.

20. Oven according to Claim 13 or 14, **characterized in that** the said means for blasting a gas/liquid 2-phase flow onto the substrate of the card and/or onto the package are connected to a source of liquid gas via a vacuum-insulated line.

21. Oven according to Claim 16, **characterized in that** the means for blasting a gas/solid 2-phase flow, consisting of a suspension of carbon dioxide snow in CO₂, onto the substrate of the card and/or the package are connected to a source of pressurized liquid CO₂ via an insulated line and an expansion chamber.

## Patentansprüche

1. Verfahren zur Herstellung einer Lötung zwischen metallischen Kugeln, die einen Teil eines Gehäuses vom Typ BGA oder CSP oder eines analogen Typs bilden oder dafür vorgesehen sind, und Kontaktflächen, die zu einer aufgeprägten, auf einem Träger abgeschiedenen Schaltung oder einer integrierten Schaltung gehören, die von dem Gehäuse umschlossen wird, wobei:
- auf den Kontaktflächen eine Lötcreme oder ein Haftmittelstrom abgeschieden wird,
- die Kugeln auf die Kontaktflächen platziert werden,
- und diese Gruppe in einen Lötschmelzofen eingeführt wird, um die metallischen Kugeln auf eine Temperatur über ihrer Schmelztemperatur zu bringen;
**dadurch gekennzeichnet, dass** eine verstärkte Abkühlung des Trägers und/oder des Gehäuses vorgenommen wird, um die Verweildauer der Kugeln im flüssigen Zustand zu verkürzen, wobei die Kugeln einer Abkühlgeschwindigkeit von mindestens 5°C/Sekunde unterzogen werden.

2. Verfahren nach Anspruch 1, **dadurch gekennzeichnet, dass** die Kugeln einer Abkühlgeschwindigkeit von zwischen 5 und 10°C/Sekunde unterzogen werden.

3. Verfahren nach Anspruch 1 oder 2, **dadurch gekennzeichnet, dass** die Verweildauer der Kugeln im flüssigen Zustand während des Abkühlens ungefähr zwischen 3 und 6 Sekunden beträgt.

4. Verfahren nach einem der Ansprüche 1 bis 3, **dadurch gekennzeichnet, dass** die Gesamtverweildauer der metallischen Kugeln im flüssigen Zustand zwischen 20 und 65 Sekunden beträgt.

5. Verfahren nach einem der Ansprüche 1 bis 4, **dadurch gekennzeichnet, dass** die Kontaktfläche eine aus Phosphor einschließendem Nickel bestehende Endschicht, die gegebenenfalls von einem Goldüberzug bedeckt ist, umfasst und dass die metallischen Kugeln aus einer auf Zinn und Blei basierenden Legierung bestehen.

6. Verfahren nach Anspruch 5, **dadurch gekennzeichnet, dass** die metallischen Kugeln und die Lötcreme oder der Haftmittelstrom einer Temperatur, einer Verweildauer im flüssigen Zustand und einer Abkühlgeschwindigkeit unterzogen werden, so dass es an der Schnittstelle zwischen Kugel und Kontaktfläche zur Bildung einer zwischenmetallischen Schicht aus Zinn, Nickel und Phosphor mit einer maximalen Dicke von 0,5 µm kommt.

7. Karte umfassend mindestens eine aufgeprägte, auf einem Träger abgeschiedene Schaltung und mindestens eine von einem Gehäuse vom Typ BGA oder CSP oder eines analogen Typs umschlossene integrierte Schaltung, **dadurch gekennzeichnet, dass** sie durch das Verfahren nach einem der Ansprüche 1 bis 6 erhalten werden kann.

8. Gehäuse vom Typ BGA oder CSP oder eines analogen Typs, **dadurch gekennzeichnet, dass** es durch das Verfahren nach einem der Ansprüche 1 bis 6 erhalten werden kann.

9. Lötschmelzofen zum Zusammenfügen von Karten der Art, die mindestens eine aufgeprägte, auf einem Träger abgeschiedene Schaltung und mindestens eine von einem Gehäuse vom Typ BGA oder CSP oder eines analogen Typs umschlossene integrierte Schaltung umfasst, oder zur Herstellung derartiger Gehäuse, **dadurch gekennzeichnet, dass** er am Ende des Lötbereichs Mittel zum verstärkten Abkühlen des Trägers der Karte und/oder des Gehäuses umfasst, die es ermöglichen, die Kugeln einer Abkühlgeschwindigkeit von mindestens 5°C/Sekunde zu unterziehen.

10. Ofen nach Anspruch 9, **dadurch gekennzeichnet, dass** die Mittel zum verstärkten Abkühlen aus mindestens einem Einspritzer bestehen, der auf die Unterseite des Trägers der Karte und/oder auf das Gehäuse einen Gasstrom ausstrahlt.

11. Ofen nach Anspruch 10, **dadurch gekennzeichnet, dass** er Mittel zum Abkühlen des Gases vor seiner Aufstrahlung durch den Einspritzer umfasst.

12. Ofen nach Anspruch 10 oder 11, **dadurch gekennzeichnet, dass** es sich bei dem Gas um ein Gas oder eine Gasmischung mit hoher Wärmeleitfähigkeit handelt, wie beispielsweise Wasserstoff oder Helium.

13. Ofen nach Anspruch 9, **dadurch gekennzeichnet, dass** die Mittel zum verstärkten Abkühlen aus Mitteln zum Aufstrahlen eines zweiphasigen Gas-/Flüssigkeitsstroms auf den Träger der Karte und/oder das Gehäuse bestehen.

14. Ofen nach Anspruch 13, **dadurch gekennzeichnet, dass** es sich bei dem zweiphasigen Gas-/Flüssigkeitsstrom um eine Suspension aus Tröpfchen flüssigen Stickstoffs, die von dem gasförmigen Stickstoff transportiert werden, handelt.

15. Ofen nach Anspruch 9, **dadurch gekennzeichnet, dass** die Mittel zum verstärkten Abkühlen aus Mitteln zum Aufstrahlen eines zweiphasigen Gas-/Feststoffstroms auf den Träger der Karte und/oder das Gehäuse bestehen.

16. Ofen nach Anspruch 15, **dadurch gekennzeichnet, dass** es sich bei dem zweiphasigen Strom um eine Suspension aus von gasförmigem CO₂ transportiertem Kohlenstoffpulver handelt.

17. Ofen nach einem der Ansprüche 13 bis 16, **dadurch gekennzeichnet, dass** die Mittel zum Aufstrahlen eines zweiphasigen Gas-/Flüssigkeits- oder Gas-/Feststoffstroms auf den Träger der Karte und/oder das Gehäuse eine sich rechtwinklig zur Karte oder zum Gehäuse verschiebende Düse oder Düsengruppe umfassen.

18. Ofen nach einem der Ansprüche 13 bis 16, **dadurch gekennzeichnet, dass** die Mittel zum Aufstrahlen eines zweiphasigen Gas-/Flüssigkeits- oder Gas-/Feststoffstroms auf den Träger der Karte und/oder das Gehäuse eine feste Düse oder Düsengruppe umfassen, die das Gehäuse gezielt in dem Moment bestrahlen, in dem es vor der oder den Düsen passiert.

19. Ofen nach einem der Ansprüche 9 bis 18, **dadurch gekennzeichnet, dass** er Inaktivierungsmittel umfasst, die mindestens in dem Bereich, in dem das Löten und das Abkühlen des gelöteten Bereichs stattfindet, den Ausschluss von Luft bewirken.

20. Ofen nach Anspruch 13 oder 14, **dadurch gekennzeichnet, dass** die Mittel zum Aufstrahlen eines zweiphasigen Gas-/Flüssigkeitsstroms auf den Träger der Karte und/oder das Gehäuse über einen unter Vakuum isolierten Kanal mit einer Quelle für flüssiges Gas verbunden sind.

21. Ofen nach Anspruch 16, **dadurch gekennzeichnet, dass** die Mittel zum Aufstrahlen eines aus einer Suspension aus Kohlenstoffpulver in CO₂ bestehenden zweiphasigen Gas-/Feststoffstroms auf den Träger der Karte und/oder das Gehäuse über einen isolierten Kanal und eine Expansionskammer mit einer unter Druck stehenden Quelle für flüssiges CO₂ verbunden sind.
